# EUROPÄISCHE PATENTSCHRIFT

(11) **EP 2 470 920 B1**
(45) Veröffentlichungstag und Bekanntmachung des Hinweises auf die Patenterteilung: **16.10.2013**
(21) Anmeldenummer: 10737922.4
(22) Anmeldetag: 03.08.2010
(51) Int. Cl.: G01R 33/00

(54) **MAGNETFELDSENSOR**
MAGNETIC FIELD SENSOR
CAPTEUR DE CHAMP MAGNÉTIQUE

(30) Priorität: 28.08.2009 DE 102009028956
(43) Veröffentlichungstag der Anmeldung: 04.07.2012
(73) Patentinhaber: Robert Bosch GmbH, 70442 Stuttgart (DE)
(72) Erfinder: LAMMEL, Gerhard, 72070 Tübingen (DE); WEISS, Stefan, 72070 Tübingen (DE)
(86) Internationale Anmeldenummer: PCT/EP2010/061277
(87) Internationale Veröffentlichungsnummer: WO 2011/023495

(56) Entgegenhaltungen:
- DE-B3-102007 041 230
- JP-A- 2010 014 701
- US-A1- 2002 144 418

## Beschreibung

Die Erfindung betrifft einen Magnetfeldsensor und insbesondere die Kalibrierung eines solchen Sensors.

### Stand der Technik

Im Stand der Technik sind verschiedene mikromechanische Magnetfeldsensoren bekannt, die eine Wechselwirkung zwischen einem elektrischen Strom und einem Magnetfeld in eine Kraft umsetzen. So offenbart die DE 198 27 056 beispielsweise einen Mikromagnetfeldsensor, bei dem eine durch die Lorentzkraft verursachte Bewegung einer Sensorstruktur kapazitiv über kammartige Elektroden detektiert wird. Dabei wird die Lorentzkraft ausgenutzt, indem durch einen in einem (freischwebenden) elektrischen Leiter eingeprägten Strom und ein extern anliegendes Magnetfeld eine laterale Bewegung der freischwebenden Struktur hervorgerufen wird.

Ferner sind Mikro-Magnetfeldsensoren bekannt, die den Hall-Effekt ausnutzen, welcher in stromdurchflossenen Leitern in Anwesenheit eines externen Magnetfeldes auftritt. Dabei werden die Elektronen in den Leitern aufgrund des externen Magnetfeldes abgelenkt, so dass eine Potentialdifferenz zwischen den beiden Seiten des Leiters entsteht, die den Hall-Messeffekt darstellt. Weitere für die Mikrostrukturtechnik geeignete Messprinzipien sind Fluxgate-Sensoren, AMR- oder auch GMR-Sensoren.

Bei solchen in Mikrostrukturtechnik hergestellten Sensoren kann jedoch aufgrund von Toleranzen oder auch aufgrund von wechselnden Umgebungsbedingungen, wie Temperatur, Luftdruck oder dergl., ein Sensoroffset entstehen, der einen Abgleich bzw. eine Kalibrierung des Sensors notwendig macht. Im Rahmen einer solchen Kalibrierung wird am Sensorort beispielsweise ein vorbestimmtes Magnetfeld aufgeprägt und aus den unterschiedlichen Sensorausgabewerten bei anliegendem und fehlendem Magnetfeld der Sensoroffset berechnet. Die DE 198 27 056 offenbart hierfür eine als Kalibrierstromschleife ausgebildete Feldspule, die auf dem den Sensor umgebenden Substrat angeordnet ist. Somit ist die Feldspule im Mikrosensorelement selbst integriert. Eine solche Anordnung wird auch als "Coil on Chip" bezeichnet. Da die geometrische Anordnung der Feldspule sowie Leiterquerschnitt und spezifischer Widerstand bekannt sind, kann das bei einem vorgegebenen Prüfstrom entstehende Magnetfeld am Sensorort entweder rechnerisch oder experimentell ermittelt werden. Der Vorteil gegenüber externen Spulenanordnungen, die beispielsweise Teil eines Testgeräts sind, besteht darin, dass kein aufwändiges Testequipment notwendig ist, um die Homogenität und zeitliche Stabilität des Feldes am Sensorort sicherzustellen.

### Offenbarung der Erfindung

Ein erfindungsgemäßer Magnetfeldsensor zum Messen eines Magnetfeldes an einem Sensorort weist Folgendes auf:
eine Leiterplatte aus elektrisch isolierendem Material;
ein insbesondere als Mikrosystem ausgebildetes Magnetfeldsensorelement, das auf der Leiterplatte angeordnet und über elektrische Kontakte mit auf der Leiterplatte vorgesehenen ersten Leiterbahnen verbunden ist; und
mindestens eine zweite Leiterbahn zum Erzeugen eines Prüfmagnetfelds, die auf bzw. in der Leiterplatte vorgesehen ist und bei Anlegen eines Kalibrierstroms durch die zweite Leiterbahn am Sensorort ein vorbestimmtes Prüfmagnetfeld erzeugt.

Bei einem derartigen Magnetfeldsensor sind die Leiterbahnen zur Erzeugung des Prüfmagnetfeldes zum Abgleich des Magnetfeldsensors auf der Leiterplatte vorgesehen. Dies macht es möglich, auf Feldspulen im Prüfgerät zu verzichten. Ferner besteht gegenüber Anordnungen, in denen Feldspulen in ein Mikro-Magnetfeldsensorelement integriert sind, der Vorteil, dass keine Chipfläche für die integrierte Feldspule vorgesehen werden muss. Somit kann der Integrationsaufwand und folglich auch die Kosten niedrig gehalten werden. Ferner ist die thermische Belastung bei Aufprägen des Kalibrierstroms mit der erfindungsgemäßen Anordnung niedriger. Außerdem sind höhere Ströme und damit auch größere Magnetfelder möglich als bei Coil-on-Chip-Anordnungen.

Die zweite Leiterbahn kann das Magnetfeldsensorelement beispielsweise schleifenförmig umgeben. Somit wird bei Anlegen eines Kalibrierstroms am Sensorort ein im Wesentlichen zur Sensoroberfläche des Magnetfeldsensorelements senkrechtes Prüfmagnetfeld erzeugt. Ferner ist es auch möglich, auf zwei gegenüberliegenden Seiten des Magnetfeldsensorelements jeweils eine zweite Leiterbahn auf der (gleichen Seite der) Leiterplatte anzuordnen, wobei diese zwei zweiten Leiterbahnen parallel zueinander angeordnet sind. Dies hat den Vorteil, dass bei entsprechender Ansteuerung ein Prüfmagnetfeld senkrecht zur Sensoroberfläche und ein Prüfmagnetfeld tangential zur Sensoroberfläche erzeugt werden kann.

Es ist vorteilhaft, wenn die Ausdehnung der zwei parallelen Leiterbahnen in Richtung entlang einer Kante des Magnetfeldsensorelements auf deren Seite sie angeordnet sind jeweils mindestens fünf mal, vorzugsweise mindestens zehn mal größer als ihre Ausdehnung in Richtung einer senkrecht dazu angeordneten Seitenkante des Magnetfeldsensorelement. Somit wird ein relativ großes Prüfmagnetfeld am Sensorort erzeugt.

Erfindungsgemäß ist vorgesehen, dass zwei Paare von jeweils zwei parallelen Leiterbahnen zum Erzeugen eines Prüfmagnetfelds vorgesehen sind, wobei die beiden Leiterbahnpaare von oben betrachtet im rechten Winkel zueinander, jedoch elektrisch isoliert voneinander angeordnet sind. Mit einer solchen Anordnung lassen sich bei entsprechender Ansteuerung Prüfmagnetfelder in allen drei Raumrichtungen erzeugen. Dabei können die zwei Paare von Leiterbahnen auf unterschiedlichen Metallebenen der Leiterplatte angeordnet sind, um sie elektrisch voneinander zu isolieren.

Ferner wird eine Kombination eines Magnetteldsensors wie oben beschrieben mit einem Prüfgerät bereitgestellt, wobei das Prüfgerät operativ mit dem Magnetfeldsensor verbindbar ist und eingerichtet ist, einen vorbestimmten Kalibrierstroms an die mindestens eine zweite Leiterbahn anzulegen. Ein Vorteil dieser Anordnung ist, dass das Prüfgerät nicht mit einer Feldspule zur Erzeugung des Prüfmagnetfeldes ausgestattet sein muss und somit vereinfacht werden kann.

### Kurze Beschreibung der Figuren

- Fig. 1: zeigt eine perspektivische Ansicht eines Magnetfeldsensors.
- Fig. 2: zeigt ein Blockschaltbild einer Kombination eines Magnetfeldsensors mit einem Prüfgerät.
- Fig. 3: zeigt schematisch den Kalibrierstrom sowie den von diesem verursachten Prüfmagnetfeld am Sensorort
- Fig. 4: zeigt eine perspektivische Ansicht eines Magnetfeldsensors.
- Fig. 5A: ist eine perspektivische Darstellung, die schematisch den Kalibrierstrom sowie den von diesem verursachten Prüfmagnetfeld am Sensorort.
- Fig. 5B: ist eine Schnittansicht, die schematisch den Kalibrierstrom sowie den von diesem verursachten Prüfmagnetfeld am Sensorort zeigt.

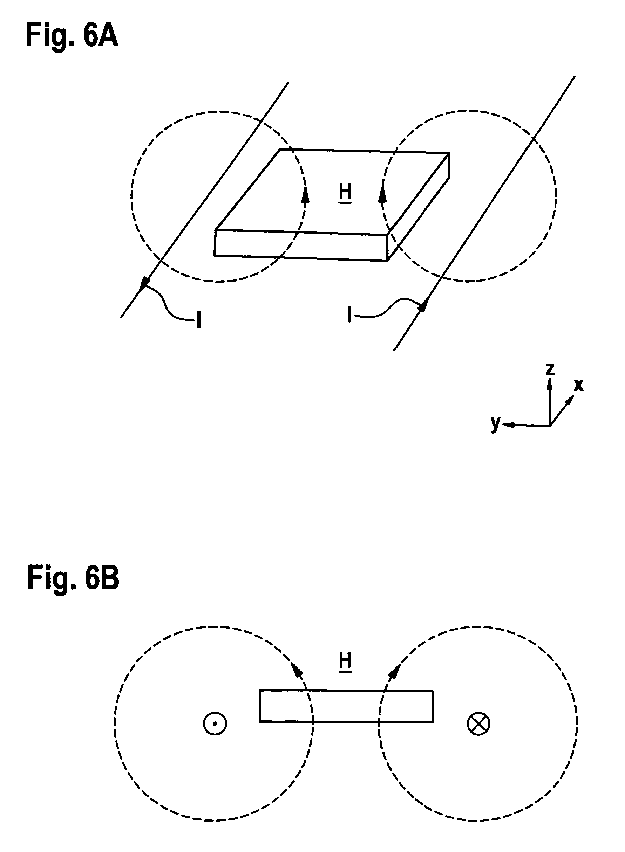

- Fig. 6A: ist eine perspektivische Darstellung, die schematisch den Kalibrierstrom sowie den von diesem verursachten Prüfmagnetfeld am Sensorort zeigt.
- Fig. 6B: ist eine Schnittansicht, die schematisch den Kalibrierstrom sowie den von diesem verursachten Prüfmagnetfeld am Sensorort zeigt.

### Ausführungsbeispiele

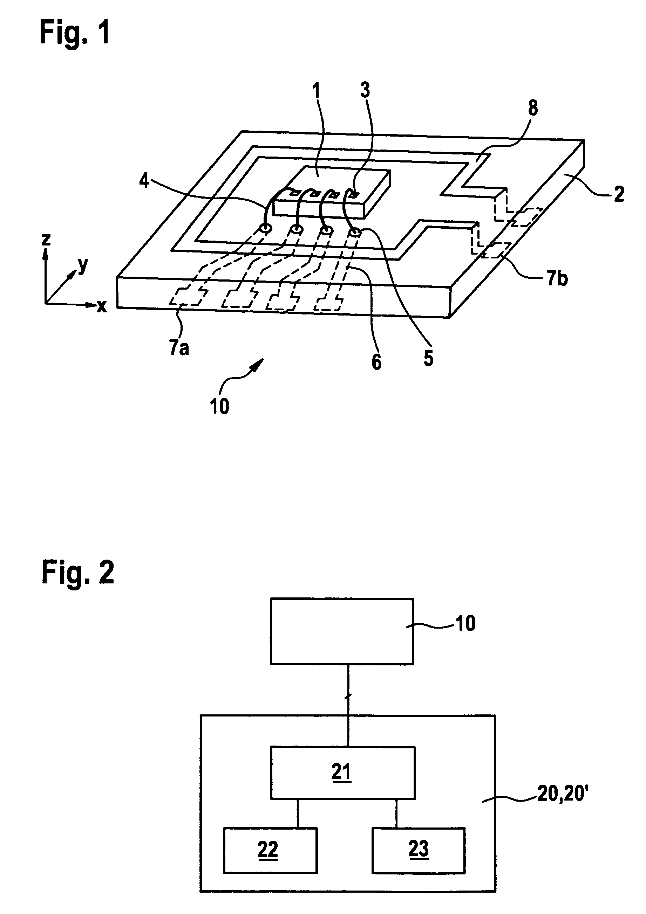

Fig. 1 zeigt eine perspektivische Ansicht eines Magnetfeldsensors 10. Der Magnetfeldsensors 10 umfasst ein Sensorelement 1, welches auf einer Leiterplatte 2 befestigt, z.B. aufgeklebt ist.

Das Sensorelement 1 ist als Mikrosystem ausgebildet, d.h. die Sensorstruktur zur Erzeugung eines Sensorsignals, das der Größe des zu messenden Magnetfeldes entspricht, ist monolithisch auf einem Halbleiterchip aus z.B. Silizium vorgesehen. Das Sensorelement 1 ist in diesem Ausführungsbeispiel als Hall-Sensor ausgebildet, und erzeugt ein analoges Signal, welches der z-Komponente des Magnetfeldes am Sensorort entspricht. Dieses analoge Signal wird tiefpassgefiltert und von einem Analog-Digital-Wandler in ein digitales Sensorsignal umgewandelt. Im vorliegenden Beispiel wird diese Weiterverarbeitung des analogen Signals durch eine in das Sensorelement 1 integrierte Datenverarbeitung durchgeführt. Es ist jedoch ebenso möglich, auf der Leiterplatte 2 einen separaten Baustein, z.B. einen ASIC, für diese Datenverarbeitung vorzusehen.

Die Leiterplatte 2 (auch als "PCB" bezeichnet) ist aus elektrisch isolierendem Material, wie z.B. faserverstärktem Kunststoff. Die Leiterplatte 2 weist mindestens zwei Metallebenen auf, die beispielsweise auf der Oberseite und der Unterseite der Leiterplatte 2 vorgesehen sind. In diesen Metallebenen sind Leiterbahnen angeordnet, die z.B. aus einer dünnen Kupferschicht geätzt sind. In Fig. 1 sind von außen eigentlich nicht sichtbare Leiterbahnen auf der Unterseite der Leiterplatte 2 sowie Durchgangskontaktierungen mit gestrichelten Linien dargestellt.

Auf dem Sensorelement 1 sind beispielsweise vier Kontakte 3 vorgesehen, die über Bonddrähte 4 mit Bondlands 5 auf der Oberseite der Leiterplatte 1 (erste Metallebene) verbunden sind. Im vorliegenden Beispiel sind die Bondlands 5 über Durchkontaktierungen mit ersten Leiterbahnen 6 verbunden, die auf der Unterseite der Leiterplatte 2 (zweite Metallebene) vorgesehen sind und die Bondlands 5 mit LGA-Anschlüssen 7a am äußeren Rand der Leiterplatte 1 verbinden.

In der ersten Metallebene der Leiterplatte 2 ist ferner eine zweite Leiterbahn 8 vorgesehen, welche das Sensorelement 1 schleifenförmig umgibt. Diese zweite Leiterbahn 8 ist über Durchkontaktierungen mit LGA-Anschlüssen 7b am Rand der Leiterplatte 1 auf der zweiten Metallebene verbunden. Diese zweite Leiterbahn 8 dient zum Anlegen eines Prüffeldes im Rahmen eines Sensorabgleichs, wie im Folgenden noch ausführlicher beschrieben wird.

Der Magnetfeldsensor 10 kann mit einem isolierenden Material umspritzt und in ein Plastikgehäuse oder dergleichen aufgenommen werden (nicht näher dargestellt). Dann kann er über mit den LGA-Anschlüssen 7a und 7b über einen LGA (Land Grid Array) mit einer Steuerung bzw. Ansteuer- und Auswerteelektronik verbunden werden.

Über zwei der LGA-Anschlüsse 7a erfolgt die Ansteuerung des Sensorelements 1. Die vom Sensorelement 1 erzeugten digitalen Signale werden über die zwei übrigen LGA-Anschlüsse 7a abgegriffen. Es hat sich jedoch gezeigt, dass gerade bei Hall-Sensoren ein Sensoroffset entsteht, der bis zu einigen Milli-Tesla entsprechen kann. Falls der Sensoroffset zu groß ist, kann der Sensor 10 unbrauchbar sein und sollte aussortiert werden.

In einer ersten Variante des ersten Ausführungsbeispiels wird beim sogenannten Endmessen, also im Anschluss an die Herstellung des Sensors 10, bei Erzeugung eines Prüffeldes mit den zweiten Leiterbahnen 8 der Sensoroffset sowie die Sensorempfindlichkeit bestimmt. Hierzu wird ein Prüfgerät 20 verwendet, wie es schematisch in Fig. 2 dargestellt ist. Dieses Prüfgerät 20 umfasst eine Steuervorrichtung 21, einen Speicher 22 und eine Signalisierungseinrichtung 23. Die Signalisierungseinrichtung 23 kann beispielsweise als optische und/oder akustische Anzeigevorrichtung ausgebildet sein. Ferner umfasst das Prüfgerät einen Platzierungsbereich (nicht näher dargestellt) mit einer Anzahl von Kontakten, die den Anschlüssen 7a, 7b auf der Leiterplatte 2 des Sensors 10 entsprechen. Durch Platzieren des Sensors 10 auf diesem Platzierungsbereich kann das Prüfgerät 20 operativ mit dem Sensor 10 verbunden werden.

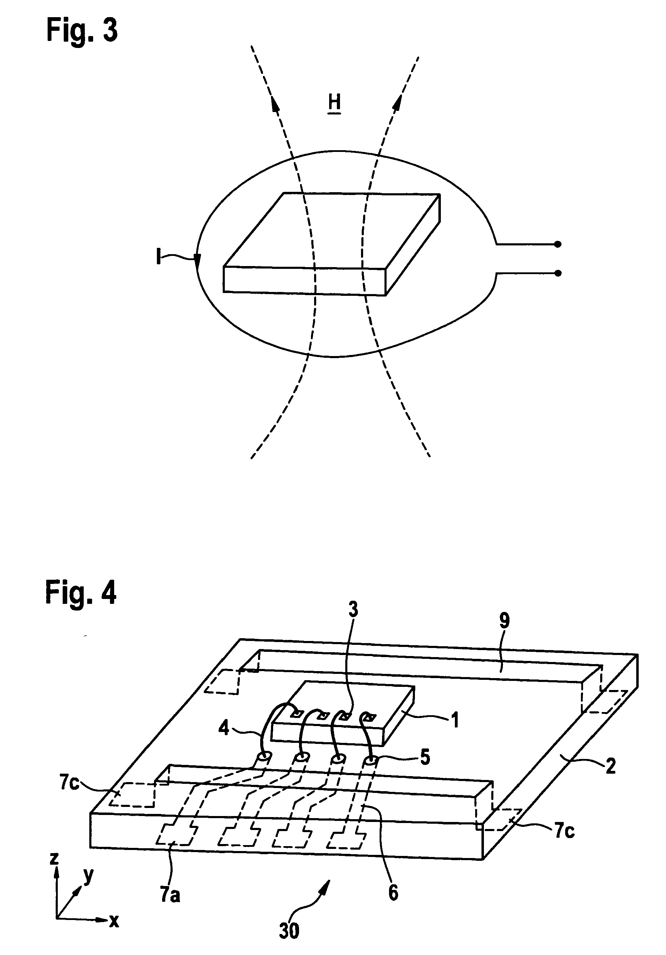

Nach dem Platzieren des Sensors 10 auf diesem Platzierungsbereich verursacht die Steuerung 21 (über eine Treiberschaltung oder dergleichen) einen vorbestimmten Kalibrierstrom von beispielsweise 0,01 bis 1000 mA durch die das Sensorelement 1 schleifenförmig umgebende zweite Leiterbahn 8 in einer ersten Stromflussrichtung. Dieser Kalibrierstrom I verursacht ein bestimmtes Prüfmagnetfeld H in z-Richtung am Sensorort. Dies ist schematisch in Fig. 3 dargestellt. Da die Geometrie des Sensors, also die Geometrie der Leiterbahnen und ihre relative Anordnung zum Sensorort, ebenso wie die Größe des Kalibrierstroms bekannt sind, ist auch die Größe des Prüfmagnetfelds bekannt. Alternativ ist es auch möglich, dieses Prüfmagnetfeld durch eine Kalibriermessung mit einem separaten Magnetometer zu bestimmen. Das Prüfmagnetfeld wird dann mit dem Sensorelement 1 gemessen. Hierzu wird das Sensorelement 1 über von der Steuerung 21 über die LGA-Anschlüsse angesteuert und das momentane (digitale) Sensorsignal ausgelesen und ein entsprechender Wert im Speicher 22 abgespeichert. Anschließend verursacht die Steuerung 21 einen vorbestimmten Kalibrierstromfluss derselben Größe aber mit umgekehrtem Vorzeichen, liest wiederum das resultierende Sensorsignal aus und speichert den entsprechenden Wert im Speicher 22 ab.

Aus den gespeicherten Werten bestimmt die Steuerung 21 nun den Offset sowie die Sensorempfindlichkeit. Falls beispielsweise das Prüfmagnetfeld +50 µT bzw. -50 µT beträgt und das dazugehörige ausgelesene (digitale) Sensorsignal 20 lsb bzw. -22 lsb (lsb = least significant bit) beträgt, dann kann auf einen Offset von 1 lsb geschlossen werden. Für die Sensorempfindlichkeit entspricht der Differenz zwischen den beiden ausgelesenen Werten dividiert durch die Differenz der Prüfmagnetfeldstärken, so dass sich in diesem Beispiel eine Sensorempfindlichkeit von 42 lsb / 100 µT ergibt. Falls der somit ermittelte Offset und/oder die Sensorempfindlichkeit größer als vorbestimmte Toleranzwerte sind, dann gibt die Steuerung 21 ein Statussignal aus an die Signalisierungsvorrichtung 23, welche z.B. optisch oder akustisch anzeigt, ob das Sensorelement 10 innerhalb der Toleranzwerte liegt oder ob es außerhalb der Toleranzwerte liegt und somit als defekt gilt.

Falls die Steuerung 21 ermittelt hat, dass das Sensorelement 10 nicht defekt ist, dann veranlasst die Steuerung 21 die Speicherung eines der Sensorempfindlichkeit entsprechenden Wertes in einem Speicherbereich des Sensorelements 1. Es ist auch möglich, den Sensoroffset im Sensorelement 1 abzuspeichern, allerdings ist hierbei zu bedenken, dass der Sensoroffset stark von den Umgebungsbedingungen am Einsatzort des Sensors abhängt. So können metallenen Komponenten und stromdurchflossene Leiter am Einsatzort zu Störfeldern führen, die den Sensoroffset beeinflussen. Auch besteht gerade bei Hall-Sensoren eine beträchtliche Temperaturabhängigkeit, die einen periodischen Abgleich bzw. eine periodische Bestimmung des Sensoroffsets sinnvoll erscheinen lässt. Dagegen ist die Sensorempfindlichkeit vergleichsweise unabhängig von den Umgebungsbedingungen am Einsatzort und kann daher auch sinnvollerweise bei der Endmessung im Sensorelement 1 abgespeichert werden, um dann später am Einsatzort referenziert zu werden.

Vorteilhaft bei dieser ersten Variante ist, dass eine Endmessung mit einem Prüfgerät durchgeführt werden kann, welches keine Spulen zur Erzeugung des Prüfmagnetfeldes aufweist. Das Prüfgerät kann somit einen vereinfachten Aufbau haben.

In einer zweiten Variante ist der Sensor 10 an seinem Einsatzort (z.B. als Lenkwinkelsensor in einem Kfz oder dergl.) eingebaut. Auch hier ist der Sensor 10 über einen LGA mit einer Sensorsteuerung 20' verbunden, welche einen Prüfstrom an die Leiterbahn 8 anlegen kann und somit einem Prüfgerät gemäß der ersten Variante bei entsprechendem Aufbau (vgl. Fig. 2) entspricht. Die Sensorsteuerung 20' bestimmt den Sensoroffset in den für die erste Variante beschriebenen Art und Weise. Dieser Sensoroffset wird im Speicher 22 abgespeichert und zur Korrektur bzw. Kalibrierung des von der Sensorsteuerung 20' ausgegebenen Sensorsignals verwendet. Vorteilhaft bei dieser zweiten Variante ist, dass der Sensor 10 jederzeit geprüft und gegebenenfalls nachkalibriert werden kann.

Fig. 4 zeigt eine perspektivische Ansicht eines Magnetfeldsensors 30. Merkmale, die dem Magnetfeldsensor 10 gemäß dem ersten Ausführungsbeispiel entsprechen, sind mit denselben Bezugszeichen gekennzeichnet und werden nicht näher erläutert.

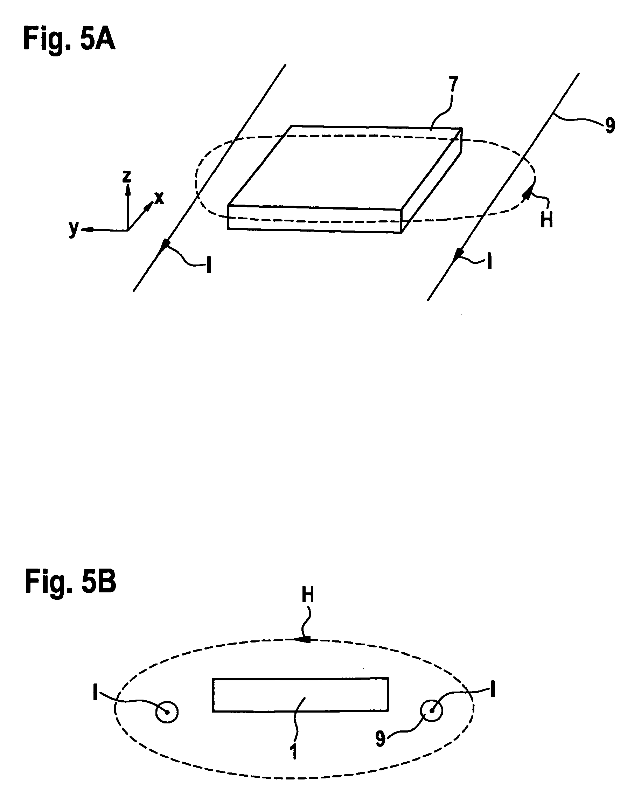

Der Magnetfeldsensors 30 unterscheidet sich von dem Magnetfeldsensor 10 durch die Anordnung der zweiten Leiterbahnen 9. Der Magnetfeldsensor 30 ist mit zwei parallelen geraden Leiterbahnen 9 versehen, die auf der ersten Metallebene angeordnet sind. Über Durchkontaktierungen sind die Leiterbahnen 9 mit LGA-Anschlüssen 9c auf der zweiten Metallebene verbunden. Die Leiterbahnen 9 sind auf zwei Seiten des Sensorelements 1 entlang dem Sensorelement 1 angeordnet. Genauer erstrecken sie sich in einer Richtung (x-Richtung) entlang der Vorderkante und der Hinterkante des Sensorelements 1 in Fig. 4, und zwar jeweils über eine Strecke, die länger ist (z.B. mindestens doppelt so lang) wie die Ausdehnung des Sensorelements 1 in Richtung dieser Kanten. Ferner ist ihre Ausdehnung in Richtung entlang der Kante auf deren Seite sie angeordnet ist (x-Richtung) wesentlich (z.B. mindestens fünf Mal oder vorzugsweise mindestens zehn Mal) größer als ihre Ausdehnung in Richtung der anderen, senkrecht dazu angeordneten Seitenkanten (y-Richtung). Der Stromfluss I durch die Leiterbahnen 9 verläuft also im Wesentlichen in einer Richtung tangential zum Sensorort. Somit wird bewirkt, dass ein Stromfluss I durch die Leiterbahnen 9 ein relativ großes Magnetfeld am Sensorort erzeugt. Dies ist schematisch in den Figuren 5A und 5B dargestellt, wobei Fig. 5A eine diagrammatische perspektivische Ansicht des Sensorelements 1 und der Leiterbahnen 9 darstellt und Fig. 5B eine diagrammatische Querschnittsansicht durch die y-z-Ebene des Sensorelements 1 und der Leiterbahnen 9 darstellt. Wie aus diesen Figuren erkennbar ist, erzeugt der Stromfluss I durch die Leiterbahnen 9 ein Magnetfeld, welches tangential zur Oberfläche des Sensorelements 1 angeordnet ist, falls der Strom durch beide Leiterbahnen 9 in dieselbe Richtung (x-Richtung oder -x-Richtung) fließt.

Im Gegensatz dazu haben die ersten Leiterbahnen 6 auf der zweiten Metallebene zwar auch eine gewisse Ausdehnung in x-Richtung, allerdings ist ihre Ausdehnung in Richtung entlang der Kante auf deren Seite sie angeordnet ist (x-Richtung) wesentlich kleiner als ihre Ausdehnung in Richtung der anderen, senkrecht dazu angeordneten Seitenkanten (y-Richtung), nämlich z.B. mindestens fünf mal oder vorzugsweise mindestens zehnmal größer in y-Richtung als in x-Richtung. Der Stromfluss durch die ersten Leiterbahnen 6 verläuft also im Wesentlichen in einer Richtung radial zum Sensorort. Somit wird bewirkt, dass ein Stromfluss durch die ersten Leiterbahnen 6 nur ein relativ kleines Stör-Magnetfeld am Sensorort erzeugt.

Mit dem in den Fign. 5A und 5B gezeigten Stromfluss, kann im Sensorelement 10 des Sensors 30 also ein Prüfmagnetfeld erzeugt werden, welches im Wesentlichen in der Ebene der Oberfläche des Sensorelements 10 (x-y-Ebene) liegt. Durch einen anti-parallelen Stromfluss durch die Leiterbahnen 9 ist es jedoch auch möglich, ein Prüfmagnetfeld H in einer Richtung senkrecht zur Oberfläche des Sensorelements 10 (z-Richtung) zu erzeugen. Die in der Fig. 4 dargestellte Leiterbahnanordnung hat also den Vorteil, dass sich mit ihr Prüfmagnetfelder in zwei senkrecht aufeinander stehenden Richtungen erzeugen lassen. Hierbei ist es vorteilhaft, wenn das Prüfgerät 20 bzw. die Sensorsteuerung 20' so eingerichtet ist, dass es bzw. sie wahlweise oder auch programmgesteuert sukzessive die zweiten Leiterbahnen 9 derart ansteuert, dass nacheinander ein Prüfmagnetfeld in der x-y-Ebene und ein Prüfmagnetfeld in z-Richtung am Sensorort erzeugt wird und die entsprechenden Messwerte im Speicher 22 abspeichert und in der oben beschriebenen Weise weiterverarbeitet. Auf diese Weise können mit einer einfachen Leiteranordnung Prüfmagnetfelder in zwei räumlichen Richtungen erzeugt werden.

Ferner ist es auch möglich, die Anordnungen der zweiten Leiterbahnen 9 in den Figuren 1 und 4 miteinander zu kombinieren, also sowohl eine schleifenförmige Leiterbahn als auch zwei parallele Leiterbahnen auf bzw. in derselben Leiterplatte vorzusehen. Hierbei ist vorzugsweise entweder die schleifenförmige Leiterbahn oder die parallelen Leiterbahnen auf einer dritten Metallebene zwischen der ersten und der zweiten Metallebene angeordnet.

Weiterhin ist es auch möglich, auf der oberen ersten Metallebene die in Fig. 4 dargestellte zwei parallele Leiterbahnen vorzusehen und auf einer dritten Metallebene zwischen der ersten und der zweiten Metallebene zwei weitere parallele Leiterbahnen, die sich (von oben betrachtet) mit den parallelen Leiterbahnen der ersten Metallebene im Winkel von etwa 90 Grad kreuzen. Mit einer solchen Anordnung können mit den parallelen Leiterbahnen der oberen ersten Metallebene Prüfmagnetfeldern in y-Richtung und z-Richtung und mit den parallelen Leiterbahnen der dritten Metallebene Prüfmagnetfeldern in x-Richtung (und z-Richtung) erzeugt werden. Gegebenenfalls ist auch hierbei eine sukzessive Ansteuerung vorteilhaft, um nacheinander Prüfmagnetfelder in allen drei Raumrichtungen zu erzeugen. Dies ist insbesondere vorteilhaft bei Magnetfeldsensoren, die ausgelegt sind, Magnetfeldkomponenten in den drei Raumrichtungen zu messen.

Obwohl die Erfindung vorstehend anhand von bevorzugten Ausführungsbeispielen beschrieben wurde, ist sie darauf nicht beschränkt, sondern auf vielfältige Art und Weise modifizierbar. Insbesondere sind verschiedene Merkmale der oben beschriebenen Ausgestaltungen miteinander kombinierbar.

Beispielsweise ist es auch möglich, anstelle eines Hall-Sensors ein Sensorelement mit einem Fluxgate-Sensor oder auch mit einem Sensor, bei dem eine durch die Lorentzkraft verursachte Bewegung einer Sensorstruktur kapazitiv über kammartige Elektroden detektiert wird, zu verwenden.

Auch ist es möglich, die Leiterbahnen 8 bzw. 9 zur Erzeugung des Prüfmagnetfeldes auf der Unterseite der Leiterplatte 2 und die mit dem Sensorelement 10 verbundenen Leiterbahnen 6 auf der Oberseite der Leiterplatte 2 anzuordnen.

## Patentansprüche

1. Magnetfeldsensor (10, 30) zum Messen eines Magnetfeldes an einem Sensorort, aufweisend:
- eine Leiterplatte (2) aus elektrisch isolierendem Material;
- ein Magnetfeldsensorelement (1), das auf der Leiterplatte (2) angeordnet und über elektrische Kontakte (3, 5) mit auf der Leiterplatte (2) vorgesehenen ersten Leiterbahnen (6) verbunden ist; und
- mindestens eine zweite Leiterbahn (8, 9) zum Erzeugen eines Prüfmagnetfelds (H), die auf der Leiterplatte (2) vorgesehen ist und bei Anlegen eines Kalibrierstroms (I) durch die zweite Leiterbahn am Sensorort ein vorbestimmtes Prüfmagnetfeld (H) erzeugt,
wobei auf zwei gegenüberliegenden Seiten des Magnetfeldsensorelements (1) jeweils eine zweite Leiterbahn (9) auf der Leiterplatte (2) angeordnet ist und diese zwei zweiten Leiterbahnen (9) parallel zueinander angeordnet sind,
**dadurch gekennzeichnet dass**
zwei Paare von jeweils zwei parallelen Leiterbahnen (9) zum Erzeugen eines Prüfmagnetfelds (H) vorgesehen sind, wobei die beiden Leiterbahnpaare von oben betrachtet im rechten Winkel zueinander, jedoch elektrisch isoliert voneinander angeordnet sind.

2. Magnetfeldsensor (10, 30) nach Anspruch 1,
wobei die Ausdehnung der zwei parallelen Leiterbahnen (9) in Richtung entlang einer Seitenkante des Magnetfeldsensorelements (1) auf deren Seite sie angeordnet sind ieweils mindestens fünf mal, vorzugsweise mindestens zehn mal größer als ihre Ausdehnung in Richtung einer senkrecht dazu angeordneten Seitenkante des Magnetfeldsensorelements (1).

3. Magnetfeldsensor (10, 30) nach Anspruch 1 oder 2,
wobei die zwei Paare von Leiterbahnen (9) auf unterschiedlichen Metallebenen der Leiterplatte (2) angeordnet sind.

4. Magnetfeldsensor (10, 30) nach einem der vorhergehenden Ansprüche,
wobei das Magnetfeldsensorelement (1) als Mikrosystem ausgebildet ist.

5. Kombination eines Magnetfeldsensor (10, 30) nach einem der vorhergehenden Ansprüche mit einem Prüfgerät (20, 20'),
wobei das Prüfgerät (20, 20') operativ mit dem Magnetfeldsensor (10, 30) verbindbar ist und eingerichtet ist, einen vorbestimmten Kalibrierstroms (I) an die mindestens eine zweite Leiterbahn (8, 9) anzulegen.

## Claims

1. Magnetic field sensor (10, 30) for measuring a magnetic field at a sensor location, having:
- a printed circuit board (2) made from an electrically insulating material;
- a magnetic field sensor element (1) which is arranged on the printed circuit board (2) and is connected via electrical contacts (3, 5) to first conductor tracks (6) provided on the printed circuit board (2); and
- at least one second conductor track (8, 9) for generating a test magnetic field (H), which second conductor track is provided on the printed circuit board (2), and generates a predetermined test magnetic field (H) at the sensor location upon application of a calibration current (I) through the second conductor track,
in each case a second conductor track (9) being arranged on the printed circuit board (2) on two opposite sides of the magnetic field sensor element (1), and said two second conductor tracks (9) being arranged parallel to one another,
**characterized in that** two pairs of two parallel conductor tracks (9) are provided in each case for generating a test magnetic field (H), the two conductor track pairs being arranged, when viewed from above, at right angles to one another, but in a fashion electrically insulated from one another.

2. Magnetic field sensor (10, 30) according to Claim 1, in which the extent of the two parallel conductor tracks (9) in a direction along a side edge of the magnetic field sensor element (1) on the side of which they are arranged is in each case at least five times, preferably at least ten times greater than their extent in the direction of a side edge of the magnetic field sensor element (1) arranged perpendicularly thereto.

3. Magnetic field sensor (10, 30) according to Claim 1 or 2,
in which the two pairs of conductor tracks (9) are arranged on different metal planes of the printed circuit board (2).

4. Magnetic field sensor (10, 30) according to one of the preceding claims, in which the magnetic field sensor element (1) is designed as a microsystem.

5. Combination of a magnetic field sensor (10, 30) according to one of the preceding claims with a test device (20, 20'), in which the test device (20, 20') can be operationally connected to the magnetic field sensor (10, 30) and is set up to apply a predetermined calibration current (I) to the at least one second conductor track (8, 9).

## Revendications

1. Capteur de champ magnétique (10, 30) pour mesurer un champ magnétique sur un lieu de détection, présentant :
- un circuit imprimé (2) en matériau électriquement isolant ;
- un élément capteur de champ magnétique (1) qui est disposé sur le circuit imprimé (2) et qui est relié par le biais de contacts électriques (3, 5) avec des premières pistes conductrices (6) prévues sur le circuit imprimé (2) ; et
- au moins une deuxième piste conductrice (8, 9) pour générer un champ magnétique de contrôle (H), laquelle est prévue sur le circuit imprimé (2) et génère un champ magnétique de contrôle (H) prédéfini au lieu de détection lors de l'application d'un courant de calibrage (I) à travers la deuxième piste conductrice, une deuxième piste conductrice (9) étant à chaque fois disposée sur le circuit imprimé sur deux côtés opposés de l'élément capteur de champ magnétique (1) et ces deux deuxièmes pistes conductrices (9) étant disposées parallèlement l'une à l'autre,
**caractérisé en ce que**
deux paires de deux pistes conductrices (9) parallèles chacune sont prévues pour générer un champ magnétique de contrôle (H), les deux paires de pistes conductrices, vue de dessus, étant disposées perpendiculairement l'une à l'autre mais tout de même isolées électriquement l'une de l'autre.

2. Capteur de champ magnétique (10, 30) selon la revendication 1, dans lequel l'extension des deux pistes conductrices (9) parallèles le long d'un bord latéral de l'élément capteur de champ magnétique (1) est à chaque fois au moins cinq fois, de préférence au moins dix fois supérieure sur le côté où elles sont disposées à leur extension dans le sens d'un bord latéral de l'élément capteur de champ magnétique (1) disposé perpendiculairement à celui-ci.

3. Capteur de champ magnétique (10, 30) selon la revendication 1 ou 2, dans lequel les deux paires de pistes conductrices (9) sont disposées sur des plans métalliques différents du circuit imprimé (2).

4. Capteur de champ magnétique (10, 30) selon l'une des revendications précédentes, dans lequel l'élément capteur de champ magnétique (1) est réalisé sous la forme d'un microsystème.

5. Combinaison d'un capteur de champ magnétique (10, 30) selon l'une des revendications précédentes avec un appareil de contrôle (20, 20'), l'appareil de contrôle (20, 20') pouvant être relié de manière fonctionnelle avec le capteur de champ magnétique (10, 30) et étant conçu pour appliquer un courant de calibrage (I) prédéfini à l'au moins une deuxième piste conductrice (8, 9).
